# EUROPEAN PATENT SPECIFICATION

(11) **EP 2 943 539 B1**
(45) Date of publication and mention of the grant of the patent: **01.03.2023**
(21) Application number: 14700762.9
(22) Date of filing: 13.01.2014
(51) Int. Cl.: C09D 5/32, C08K 3/04, C08K 3/08, H05K 9/00

(54) **ELECTROMAGNETIC ABSORBING COMPOSITION**
ELEKTROMAGNETISCHE ABSORBIERENDE ZUSAMMENSETZUNG
COMPOSITION ABSORBANT LES ONDES ÉLECTROMAGNÉTIQUES

(30) Priority: 14.01.2013 GB 201300568
(43) Date of publication of application: 18.11.2015
(73) Proprietor: BAE SYSTEMS plc, London SW1Y 5AD (GB)
(72) Inventor: DAVIES, Joseph, Maurice, Bristol South Gloucestershire BS34 7QW (GB); HAQ, Sajad, Bristol South Gloucestershire BS34 7QW (GB); DUNLEAVY, Michael, Bristol South Gloucestershire BS34 7QW (GB); CHURCH, Simon, Robert, Bristol South Gloucestershire BS34 7QW (GB)
(74) Representative: BAE SYSTEMS plc Group IP Department
(86) International application number: PCT/GB2014/050085
(87) International publication number: WO 2014/108703

(56) References cited:
- EP-A1- 1 912 487
- WO-A1-2010/109174
- US-A1- 2010 270 069
- QING Y ET AL: "Epoxy-silicone filled with multi-walled carbon nanotubes and carbonyl iron particles as a microwave absorber", CARBON, ELSEVIER, OXFORD, GB, vol. 48, no. 14, 16 July 2010 (2010-07-16) , pages 4074-4080, XP027247367, ISSN: 0008-6223 [retrieved on 2010-07-16]
- LI Y ET AL: "Multiband microwave absorption films based on defective multiwalled carbon nanotubes added carbonyl iron/acrylic resin", PHYSICA B. CONDENSED MATTER, AMSTERDAM, NL, vol. 404, no. 8-11, 1 May 2009 (2009-05-01), pages 1343-1346, XP026040119, ISSN: 0921-4526, DOI: 10.1016/J.PHYSB.2008.12.015 [retrieved on 2009-04-10]
- DATABASE WPI Week 200422 Thomson Scientific, London, GB; AN 2004-231911 XP002720810, -& JP 2004 047965 A (SEIKO INSTR INC) 12 February 2004 (2004-02-12)
- DATABASE WPI Week 201023 Thomson Scientific, London, GB; AN 2010-C19665 XP002720807, & RU 2 380 867 C1 (UNIV MOSC POWER TECH) 27 January 2010 (2010-01-27)

## Description

The invention relates to EM field absorbing compositions, particularly lightweight iron and carbon loaded compositions. The composition finds particular use as a radar absorbing coating for structures. There are further provided coated surfaces comprising the composition, methods of absorbing EM radiation, and methods of use of such a composition, such that a surface coated in the composition is capable of absorbing EM radiation

Qing Y et al. "Epoxy-silicone filled with multi-walled carbon nanotubes and carbonyl iron particles as a microwave absorber" discloses microwave absorbing composites with epoxy-silicone matrix and 0.15-1.5 vol% of multi-walled carbon nanotubes and 50 vol% of carbonyl iron particles, having a diameter between 2-5 micrometers.

Li Y et al. "Multiband microwave absorption films based on defective multiwalled carbon nanotubes added carbonyl iron/acrylic resin" discloses microwave absorbing composites with an acrylic matrix and 1 wt% defective multiwalled carbon nanotubes and 70 wt% carbonyl iron particles, having an average diameter of 4-7 micrometers.

According to a first aspect of the invention there is provided an electromagnetic radiation absorbing composition comprising an admixture of carbon nanotubes present in the range of from 0.1 to 3 v/v% dried, magnetic particulates with an average longest dimension of at least 1 micron, present in the range of from 15 to 30%v/v dried, in a non-conductive binder.

Preferably the magnetic particulates are micron particulates with an average longest dimension in the range of 1 to 100 microns, preferably 1 to 50 microns. The particulates may be substantially spherical or high aspect ratio particulates, such as, for example a leaf or flake particulates.

The magnetic particulates may be any magnetic particulate, such as, for example iron, nickel and cobalt or magnetic alloys thereof.

The volume percentages are defined as a volume percentage of the final dried composition (i.e. without solvent). The composition may be dissolved in a solvent, such that said composition may be deposed to a surface, structure or body, in the form of a coating which may comprise at least one layer of said composition. It may be desirable to add sufficient solvent such that the composition may be applied to achieve the required final dried coating thickness in order to absorb at the frequency of the incident radiation. The composition may comprise a liquid formulation prior to application, and will preferably be in the form of a dried or cured coating after its application.

Preferably the carbon nanotubes are present in the range of 0.5 to 3%v/v. The carbon nanotubes have a length in the range of from 0.1 to 100microns. The addition of less than 5%v/v carbon nanotubes has been shown to allow the magnetic particulate content to be reduced by a significant amount, with no loss in radar absorbance, thereby, allowing the magnetic particulates to only be present in the in the range of from 15-30%v/v, more preferably 15 to 25%v/v. The reduction of the %v/v of magnetic particulate content provides a significant weight saving, which may be of the order of several hundred kilograms for an application to a surface, structure or body which possess a large surface area to be covered.

The admixture of micron sized magnetic particulates and nano-sized carbon nanotube particulates allows only minimal point contact between the magnetic particulates and carbon nanotube particulates, such that the carbon nanotube particulates are non-magnetised carbon nanotube particulates. The carbon nanotube particulates are non-magnetic carbon nanotube particulates, such that they are not coated or layered with a magnetic material, instead the non-magnetised carbon nanotube particulates are simply mixed with the magnetic particulates.

The addition of the carbon nanotube particulates to a magnetic particulate loaded composition allows a means of providing a very low mass method of controlling the permittivity without affecting the permeability of the composition. If the carbon nanotubes were coated with a magnetic coating this would not be possible, as the permeability would also increase.

The non-conductive binder may be selected from any commercially available binder; preferably it may be selected from an acrylate binder (such as, for example, methyl methacrylate MMA), an acrylic binder, an epoxy binder, a urethane & epoxy-modified acrylic binder, a fluoro-elastomeric binder, a polysulphide binder, or a polyurethane binder, preferably a two part polyurethane binder.

The binders, thickeners and dispersion agents as routinely used in typical material formulations are not volatile and so will typically not be lost during the curing i.e. drying process. In contrast to the binders, the solvent that is added to aid deposition or application may evaporate during the drying process. A number of thickeners and solvents, such as, for example, those routinely used in material formulations, may be added to the composition in order to improve the flow during application and improve its adherence to different surfaces. Solvents may be organic such as, for example alkyl acetates, such as butyl acetate or aqueous media.

According to a further aspect of the invention there is provided a surface, structure or body comprising at least one dried layer of a composition as defined according to claims 1 to 5.

According to a further aspect of the invention there is provided the use of a composition as defined herein, wherein the composition is applied to a surface, structure or body or portions thereof, preferably at a selected thickness, so as to provide a coating capable of absorbing electromagnetic radiation.

According to a further aspect of the invention there is provided a vehicle vessel or craft comprising at least one layer of composition as defined herein.

According to a yet further aspect of the invention there is provided a method of providing absorption of electromagnetic radiation on a surface structure or body or portions thereof, comprising the steps of applying at least one coat of composition as defined herein, to a first side of said surface structure or body or portions thereof, and optionally to a second side.

## Claims

1. An electromagnetic radiation absorbing composition comprising an admixture of carbon nanotubes present in the range of from 0.1 to 3v/v% dried, magnetic particulates with an average longest dimension of at least 1 micron, present in the range of from 15 to 30%v/v dried, in a non-conductive binder.

2. A composition according to claim 1, wherein the carbon nanotubes are present in the range of 0.5 to 3%v/v.

3. A composition according to claim 1 or 2 wherein the composition further comprises one or more selected from high shear thickeners, low shear thickeners, and dispersion additives.

4. A composition according to anyone of the preceding claims wherein the binder is selected from an acrylate, an epoxy binder, an acrylic, a urethane & epoxy modified acrylic, a polyurethane, a fluoro-elastomer, and a polysulphide.

5. A composition according to anyone of the preceding claims wherein the composition further comprises a solvent.

6. A surface, structure or body comprising at least one dried layer of a composition according to anyone of claims 1 to 5.

7. The use of a composition according to anyone of claims 1 to 5, wherein the composition is applied to a surface, structure or body or portions thereof to provide a coating capable of absorbing electromagnetic radiation..

8. A vehicle vessel or craft comprising at least one layer of composition according to any one of claims 1 to 5.

9. A method of providing absorption of electromagnetic radiation on a surface structure or body or portions thereof, comprising the steps of, applying at least one coat of composition according to anyone of claims 1 to 5 to a first side of said surface structure or body or portions thereof, and optionally to a second side.

## Patentansprüche

1. Zusammensetzung, die elektromagnetische Strahlung absorbiert, umfassend eine Beimischung aus Kohlenstoffnanoröhren, die in dem Bereich von 0,1 bis 3 % v/v getrocknet vorliegen, magnetische Partikel mit einer durchschnittlichen längsten Abmessung von mindestens 1 Mikrometer, die in dem Bereich von 15 bis 30 % v/v getrocknet in einem nicht-leitfähigen Bindemittel vorliegen.

2. Zusammensetzung nach Anspruch 1, wobei die Kohlenstoffnanoröhrchen in dem Bereich von 0,5 bis 3 % v/v vorliegen.

3. Zusammensetzung nach Anspruch 1 oder 2, wobei die Zusammensetzung ferner einen oder mehrere ausgewählt aus Verdickungsmitteln mit hoher Scherung, Verdickungsmitteln mit geringer Scherung und Dispersionsadditiven umfasst.

4. Zusammensetzung nach einem der vorstehenden Ansprüche, wobei das Bindemittel aus einem Acrylat, einem Epoxidharzbindemittel, einem Acryl, einem Urethan und Epoxidharzmodifizierten Acryl, einem Polyurethan, einem Fluorelastomer und einem Polysulfid ausgewählt ist.

5. Zusammensetzung nach einem der vorstehenden Ansprüche, wobei die Zusammensetzung ferner ein Lösungsmittel umfasst.

6. Oberfläche, Struktur oder Körper, umfassend mindestens eine getrocknete Schicht einer Zusammensetzung nach einem der Ansprüche 1 bis 5.

7. Verwendung einer Zusammensetzung nach einem der Ansprüche 1 bis 5, wobei die Zusammensetzung auf eine Oberfläche, eine Struktur oder einen Körper oder Abschnitte davon aufgetragen wird, um eine Beschichtung bereitzustellen, die in der Lage ist, elektromagnetische Strahlung zu absorbieren.

8. Fahrzeug, Schiff oder Luftfahrzeug, umfassend mindestens eine Schicht einer Zusammensetzung nach einem der Ansprüche 1 bis 5.

9. Verfahren zum Bereitstellen einer Absorption elektromagnetischer Strahlung auf einer Oberflächenstruktur oder einem Körper oder Abschnitten davon, umfassend die Schritte des Auftragens mindestens einer Schicht einer Zusammensetzung nach einem der Ansprüche 1 bis 5 auf eine erste Seite der Oberflächenstruktur oder des Körpers oder Abschnitten davon und optional auf eine zweite Seite.

## Revendications

1. Composition absorbant le rayonnement électromagnétique comprenant un mélange de nanotubes de carbone présents dans la plage de 0,1 à 3 % v/v de particules magnétiques séchées avec une dimension moyenne la plus longue d'au moins 1 micron, présentes dans la plage de 15 à 30 % v/v séchée, dans un liant non conducteur.

2. Composition selon la revendication 1, dans laquelle les nanotubes de carbone sont présents dans la plage de 0,5 à 3 % v/v.

3. Composition selon la revendication 1 ou 2, dans laquelle la composition comprend en outre un ou plusieurs choisis parmi des épaississants à cisaillement élevé, des épaississants à faible cisaillement et des additifs de dispersion.

4. Composition selon l'une quelconque des revendications précédentes, dans laquelle le liant est choisi parmi un acrylate, un liant époxy, un acrylique, un acrylique modifié à l'uréthane et à l'époxy, un polyuréthane, un fluoroélastomère et un polysulfure.

5. Composition selon l'une quelconque des revendications précédentes, dans laquelle la composition comprend en outre un solvant.

6. Surface, structure ou corps comprenant au moins une couche séchée d'une composition selon l'une quelconque des revendications 1 à 5.

7. Utilisation d'une composition selon l'une quelconque des revendications 1 à 5, dans laquelle la composition est appliquée sur une surface, une structure ou un corps ou des parties de ceux-ci pour fournir un revêtement capable d'absorber un rayonnement électromagnétique.

8. Véhicule bateau ou embarcation comprenant au moins une couche de composition selon l'une quelconque des revendications 1 à 5.

9. Procédé pour fournir l'absorption d'un rayonnement électromagnétique sur une structure de surface ou un corps ou des parties de ceux-ci comprenant les étapes consistant à appliquer au moins une couche de composition selon l'une quelconque des revendications 1 à 5 sur un premier côté de ladite structure de surface ou corps ou des parties de ceux-ci, et éventuellement à un second côté.
